# EUROPÄISCHE PATENTSCHRIFT

(11) **EP 2 654 209 B1**
(45) Veröffentlichungstag und Bekanntmachung des Hinweises auf die Patenterteilung: **23.02.2022**
(21) Anmeldenummer: 13163742.3
(22) Anmeldetag: 15.04.2013
(51) Int. Cl.: H03M 13/01, H03M 13/29, H04L 1/20

(54) **Verfahren und Vorrichtung zur Ermittlung einer Bitfehlerrate bei seriell verkettten LDPC und Blockkodes**
Method and device for determining of a bit error rate for serial concatenated LDPC and block codes
Procédé et dispositif de détermination d'un taux d'erreurs de bits pour des codes LDPC et des codes de blocs concaténés en série

(30) Priorität: 19.04.2012 DE 102012206436
(43) Veröffentlichungstag der Anmeldung: 23.10.2013
(73) Patentinhaber: Rohde & Schwarz GmbH & Co. KG, 81671 München (DE)
(72) Erfinder: Mayer, Timo, Dr., 80809 München (DE)
(74) Vertreter: Rupp, Christian

(56) Entgegenhaltungen:
- CN-B- 101 404 561
- URARD P ET AL: "A 135Mb/s DVB-S2 compliant codec based on 64800b LDPC and BCH codes", PROC. IEEE INTERNATIONAL SOLID-STATE CIRCUITS CONFERENCE 2005, SAN FRANCISCO, CA, USA FEB. 6-10, 2005, IEEE, PISCATAWAY, NJ, USA, Februar 2005 (2005-02), Seiten 446-609Vol.1, XP031173838, DOI: 10.1109/ISSCC.2005.1494061 ISBN: 978-0-7803-8904-5
- DON J TORRIERI: "THE INFORMATION-BIT ERROR RATE FOR BLOCK CODES", IEEE TRANSACTIONS ON COMMUNICATIONS, IEEE SERVICE CENTER, PISCATAWAY, NJ. USA, Bd. COM-32, Nr. 4, 1. April 1984 (1984-04-01), Seiten 474-476, XP002697792, ISSN: 0090-6778
- Robert H. Morelos-Zaragoza: "The Art of Error Correcting Coding", 2002, Wiley & Sons, XP002697793, ISBN: 0-470-84782-4 Seiten 1-21, * Seite 12 - Seite 16 *

## Beschreibung

Die Erfindung betrifft ein Verfahren und eine Vorrichtung zur Ermittlung einer Bitfehlerrate insbesondere in einem digitalen Fernsehübertragungssystem, insbesondere in einem digitalen Fernsehübertragungssystem nach dem sog. Digital-Video-Broadcast-Terrestrial-2(DVB-T2)-Standard, dem Digital-Video-Broadcast-Satellite-2(DVB-S2)-Standard oder dem Digital-Video-Broadcast-Cable-2(DVB-C2)-Standard.

In einem digitalen Fernsehübertragungssystem nach dem DVB-T2-, DVB-S2- oder DVB-C2-Standard wird zur Kanalkodierung der zu sendenden Datenpakete ein Low-Density-Parity-Check(LDPC)-Kode (Kode mit Überprüfung mit einer schwach besetzten Paritätsmatrix) verwendet. Aufgrund von Abhängigkeiten zwischen den einzelnen Kodierungsbits eines LDPC-kodierten Daten-Worts ist oftmals eine vollständige Korrektur von fehlerhaften Bits in einem LDPC-kodierten Daten-Wort durch einen LDPC-Dekodierer nicht möglich. Zur Verringerung der Anzahl von fehlerhaften Bits im LDPC-dekodierten Daten-Wort wird eine verkettete Dekodierung bestehend aus einem LDPC-Dekodierer und einem nachgeschalteten Bose-Chaudhuri-Hocquengham(BCH)-Dekodierer realisiert. Der BCH-Dekodierer arbeitet typischerweise mit einer hohen Kode-Rate, die näherungsweise fast den Wert eins besitzt, und reduziert bzw. beseitigt die wenigen im LDPC-dekodierten Daten-Wort noch vorhandenen fehlerhaften Bits.

Die Bestimmung der Bit-Fehlerrate am Ausgang des LDPC-Dekodierers geht aus der CN 101404561 A hervor. Die Ermittlung der Bit-Fehlerrate basiert auf der Ermittlung der Anzahl von Check-Knoten in einem für die LDPC-Dekodierung typischerweise verwendeten Tanner-Graph, die die Eigenschaft aufweisen, dass die Modulo-2-Summe aller dem Bitwert Eins jeweils Modulus-2-addierten Bitwerte von mit dem jeweiligen Check-Knoten über Kanten jeweils verbundenen variablen Knoten einen Wert größer als Null aufweisen. Die ermittelte Anzahl von Checkknoten mit dieser Eigenschaft wird zur Ermittlung der Anzahl von fehlerhaften Bits in einem LDPC-dekodierten Daten-Wort quadriert. Wird die Anzahl von fehlerhaften Bits in einem LDPC-dekodierten Daten-Wort für mehrere aufeinander folgend empfangene kodierte Daten-Worte ermittelt und eine Mittelung zugeführt, erhält man die Bit-Fehlerrate am Ausgang des LDPC-Dekodierers.

Weiterhin offenbart das Dokument "A 135 Mb/s DVB-S2 compliant codec based on 64800b LDPC and BCH codes" (Urard P. et al, Proc. IEEE International Solid-State Circuits Conference, 2005, San Franzisco, CA, USA, Feb. 6-10, 2005, IEEE, Piscataway, NJ, USA, Februar 2005, Seiten 446-609, Vol. 1) eine Serienschaltung eines LDPC-Dekodierers und eines Block-Dekodierers und eine Ermittlungseinheit, die die Paketfehlerrate am Ausgang des Block-Dekodierers bestimmt.

Ferner beschreibt das Dokument "The information-bit error rate for block codes" (Don J. Torrieri, IEEE Transactions on Communications, IEEE, Service Center, Piscataway, NJ, USA, Bd. COM-32, Nr. 4, 1. April 1984, Seiten 474-476) den Zusammenhang zwischen der Paketfehlerrate und dem Dekodierungsalgorithmus des Block-Dekodierers.

Zudem zeigt das Dokument "The art of error correcting coding" (Robert H. Morelos-Zaragoza, 2002, Wiley & Sons, Seiten 1 bis 21) die Blockkodierung und die Ermittlung der Paketfehlerrate bei der Blockkodierung.

Eine Fehlerkorrektur mit RS grouping codes und LDPC-Codes geht aus der CN 101 404 561 B hervor.

Aus der Bit-Fehlerrate am Ausgang des LDPC-Dekodierers kann über einen Bitvergleich die Bit-Fehlerrate am Eingang des LDPC-Dekodierers geschätzt werden. Eine halbwegs korrekte Ermittlung der Bit- oder Paketfehlerrate am Ausgang des BCH-Dekodierers ist aufgrund der hohen Kode-Rate des BCH-Dekodierers nachteilig nicht möglich.

Es ergibt sich folgendes Problem, das der vorliegenden Erfindung zu Grunde liegt:
Die Ermittlung der Bit- oder Paketfehlerrate am Eingang und am Ausgang eines Dekodierers wird im Fall einer BloccKodierung vereinfacht durch Vergleich der Bits im Daten-Wort am Ausgang des Dekodierers mit den entsprechenden Bits im Daten-Wort am Eingang des Dekodierers ermittelt.

Ein korrektes Ergebnis wird mit einer derartigen Vorgehensweise nur bei Kodierungsverfahrens mit einer vergleichsweise niedrigen Kode-Rate erzielt, bei denen anzunehmen ist, dass die Bits im Daten-Wort am Ausgang des Dekodierers korrekt dekodiert sind.

Somit kann bei einer verketteten Dekodierung mit einem LDPC-Dekodierer und einem nachgeschalteten BCH-Dekodierer bei bekannter Bit-Fehlerrate am Ausgang des LDPC-Dekodierers aufgrund des sehr mächtigen LDPC-Dekodierers, der eine vergleichsweise niedrige Kode-Rate aufweist, lediglich die Bit- oder Paketfehlerrate am Eingang des LDPC-Dekodierers bestimmt werden.

Aufgabe der Erfindung ist es deshalb, ein Verfahren und eine Vorrichtung zur Ermittlung der Bitfehlerrate am Ausgang einer verketteten Dekodierung zu schaffen.

Die Aufgabe wird durch ein erfindungsgemäßes Verfahren zur Ermittlung einer Bitfehlerrate mit den Merkmalen des Patentanspruchs 1 und durch eine erfindungsgemäße Vorrichtung zur Ermittlung einer Bitfehlerrate mit den Merkmalen des Patentanspruchs 8 gelöst. Vorteilhafte technische Erweiterungen sind in jeweils abhängigen Patentansprüchen aufgeführt.

Erfindungsgemäß wird die Bitfehlerrate am Ausgang der zweiten Dekodierungsstufe der verketteten Dekodierung, die als Block-Dekodierung, bevorzugt als BCH-Dekodierung, mit einer Kode-Rate von vorzugsweise fast Eins realisiert ist, aus der ermittelten Bit- und/oder Paketfehlerrate am Ausgang der LDPC-Dekodierung und der Anzahl von durch die Block-Dekodierung korrigierbaren Bits im kodierten Daten-Wort bestimmt.

Ist in einer bevorzugten ersten Variante der Erfindung die Anzahl der fehlerhaften und noch zu korrigierenden Bits des dekodierten Daten-Worts am Ausgang der LDPC-Dekodierung kleiner oder gleich der Anzahl von durch die Blockdekodierung korrigierbaren Bits, so kann am Ausgang des Block-Dekodierers eine Bit- oder Paketfehlerrate von Null realisiert werden. Ist in dieser ersten Variante der Erfindung die Anzahl der fehlerhaften und noch zu korrigierenden Bits des dekodierten Daten-Worts am Ausgang der LDPC-Dekodierung dagegen größer als die Anzahl von durch die Blockdekodierung korrigierbaren Bits, so wird das richtige Daten-Wort vom Block-Dekodierer nicht gefunden. Der Block-Dekodierer wird in diesem Fall eine Anzahl von durch ihn korrigierbaren Bits im zu dekodierenden Daten-Wort korrigieren und dabei auf ein gültiges Daten-Wort stoßen, da der Block-Dekodierer hinsichtlich seiner Korrekturfähigkeit auf die fehlende Korrekturfähigkeit des vorausgehenden LDPC-Dekodierers ausgelegt ist.

Das vom Block Dekodierer dekodierte Daten-Wort wird aber typischerweise kein korrektes Daten-Wort darstellen. Eine Dekodierung über mehrere aufeinander folgende kodierte Daten-Worte wird immer wieder zu einem gültigen und nicht korrekten Daten-Wort führen, so dass nach einem Mitteln über die Dekodierung-Ergebnisse keine Verbesserung der Bit- oder Paketfehlerrate am Ausgang der Block-Dekodierung gegenüber der Bit- oder Paketfehlerrate am Ausgang der LDPC-Dekodierung erzielt werden kann und somit die Bit- oder Paketfehlerrate am Ausgang der Block-Dekodierung in diesem Fall der ermittelbaren Bit- oder Paketfehlerrate am Ausgang der LDPC-Dekodierung entspricht.

Für die Ermittlung der Bit- oder Paketfehlerrate am Ausgang des LDPC-Dekodierers wird bevorzugt, wie oben schon erwähnt wurde, die quadrierte und über mehrere empfangene kodierte Daten-Worte gemittelte Anzahl von Check-Knoten in einem für die LDPC-Dekodierung typischerweise verwendeten Tanner-Graph ermittelt, die die Eigenschaft aufweisen, dass die Modulo-2-Summe der mit dem Bitwert Eins jeweils modulus-2-addierten Bitwerte von mit dem jeweiligen Check-Knoten über Kanten jeweils verbundenen variable Knoten einen Wert größer als eins aufweisen.

Da die Bitanzahl eines kodierten oder dekodierten Daten-Worts bei einer LDPC-Kodierung in einem digitalen Fernsehübertragungssystem in einer fünfstelligen Größenordnung liegt und gleichzeitig meist in 98% bis 99% aller empfangenen kodierten Daten-Worte ein variabler Knoten in einem Tanner-Graph jeweils mit bis zu drei Check-Knoten über jeweils eine Kante verbunden ist und gleichzeitig die Anzahl von durch einen LDPC-Dekodierer in einem kodierten Daten-Wort zu korrigierenden Bits typischerweise in einer zweistelligen Größenordnung liegt, ist davon auszugehen, dass die Check-Knoten, die jeweils mit einem variablen Knoten verbunden sind, der jeweils einen fehlerhaften und von einem Block-Dekodierer korrigierbaren Bitwert aufweist, jeweils voneinander verschieden sind.

Somit werden maximal eine Anzahl von Check-Knoten in einem Tanner-Graph, die der dreifachen Anzahl von durch einen Block-Dekodierer korrigierbaren Bits entsprichen und die jeweils alle die Eigenschaft aufweisen, dass die Modulo-2-Summe aller mit jeweils einem Bitwert Eins Modulus-2-addierten Bitwerte von mit dem jeweiligen Check-Knoten über Kanten jeweils verbundenen variablen Knoten einen Wert größer als Null aufweisen, durch einen derartigen Block-Dekodierer alle fehlerhaften Bits in einem LDPC-dekodierten Daten-Wort von der Block-Dekodierung korrigiert.

Eine zur Darstellung der LDPC-Dekodierung anhand eines Tanner-Graphs äquivalente Darstellung ist die Darstellung anhand der Paritätsmatrix. Die Bit-Fehlerrate ergibt sich in dieser Darstellung aus der quadrierten und über mehrere empfangene kodierte Daten-Worte gemittelten Anzahl von zu einer Paritätsmatrix der LDPC-Dekodierung gehörigen Zeilen, die jeweils die Eigenschaft aufweisen, dass die Modulus-2-Summe aller mit den Matrixelementen der jeweiligen Zeilen Modulus-2-addierten Bits des LDPC-dekodierten Daten-Worts einen von Null verschiedenen Wert ergibt.

Somit wird in einer zweiten Variante der Erfindung die Block-Dekodierung ein gültiges und korrektes Daten-Wort erfindungsgemäß erzeugen, wenn die Anzahl der zu einer Paritätsmatrix der LDPC-Dekodierung gehörigen Zeilen mit der Eigenschaft, dass die Modulus-2-Summe der mit den Matrixelemente der jeweiligen Zeile Modulus-2-addierten Bits des LDPC-dekodierten Daten-Worts einen von Null verschiedenen Wert ergibt, kleiner oder gleich der dreifachen Anzahl von durch den Block-Dekodierer in einem LDPC-dekodierten Daten-Wort korrigierbaren Bits ist. In diesem Fall ist die Bit- oder Paketfehlerrate am Ausgang des Block-Dekodierers, insbesondere des BCH-Dekodierers, Null.

Andernfalls wird in einer bevorzugten zweiten Variante der Erfindung, wenn die Anzahl der zu einer Paritätsmatrix der LDPC-Dekodierung gehörigen Zeilen mit der Eigenschaft, dass die Modulus-2-Summe der mit den Matrixelementen der jeweiligen Zeile Modulus-2-addierten Bits des LDPC-dekodierten Daten-Worts eine von Null verschiedenen Wert ergibt, größer als die dreifache Anzahl von durch den Block-Dekodierer in einem LDPC-dekodierten Daten-Wort korrigierbaren Bits ist, der Block-Dekodierer eine Anzahl von durch ihn korrigierbaren Bits im LDPC-dekodierten Daten-Wort korrigieren und somit auf ein gültiges Daten-Wort stoßen. Das vom Block Dekodierer dekodierte Daten-Wort wird aber typischerweise kein korrektes Daten-Wort darstellen.

Es wird auch in diesem Fall die Bit- oder Paketfehlerrate am Ausgang der Block-Dekodierung der ermittelbaren Bit- oder Paketfehlerrate am Ausgang der LDPC-Dekodierung entsprechen.

Da ein Block-Dekodierer, insbesondere ein BCH-Dekodierer, in einer verketteten Dekodierer mit einem vorausgehenden LDPC-Dekodierer die Eigenschaft aufweist, dass er eine bestimmte Anzahl von fehlerhaften Bits im LDPC-dekodierten Daten-Wort korrigieren kann, wird er ein gültiges BCH-dekodiertes Daten-Wort detektieren, das am nächsten zum fehlerhaften LDPC-dekodierten Daten-Wort liegt. Dieses gültige BCH-dekodierte Daten-Wort ist aber nicht zwingend ein korrekt BCH-dekodiertes Daten-Wort und unterscheidet sich vom jeweils korrekt BCH-dekodierten Daten-Wort in einer der vom BCH-Dekodierer korrigierbaren Anzahl von Bits oder in einem Vielfachen der vom BCH-Dekodierer korrigierbaren Anzahl von Bits.

Ausführungsbeispiele des erfindungsgemäßen Verfahrens und der erfindungsgemäßen Vorrichtung zur Ermittlung einer Bitfehlerrate werden im Folgenden anhand von Ausführungsbeispielen im Detail beispielhaft erläutert. Die Figuren der Zeichnung zeigen:
- Fig. 1: eine Darstellung eines Tanner-Graphs,
- Fig. 2: eine Darstellung der Abhängigkeit zwischen der Bit-Fehlerrate und der Anzahl von Zeilen einer Paritätsmatrix mit einer Modulus-2-Summe größer Null,
- Fig. 3: ein Blockdiagramm eines Ausführungsbeispiels der erfindungsgemäßen Vorrichtung zur Ermittlung einer Bitfehlerrate,

- Fig. 4: eine Darstellung der Abhängigkeit zwischen der Auftrittswahrscheinlichkeit von variablen Knoten und dem Kantengrad eines variable Knoten und
- Fig. 5: ein Flussdiagramm eines Ausführungsbeispiels des erfindungsgemäßen Verfahrens zur Ermittlung einer Bitfehlerrate

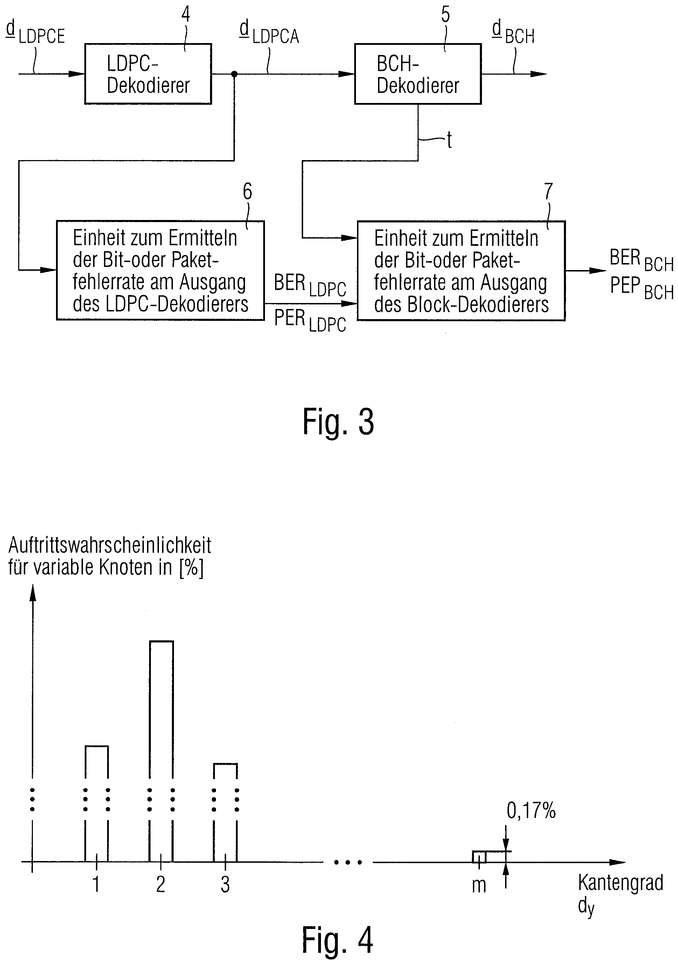

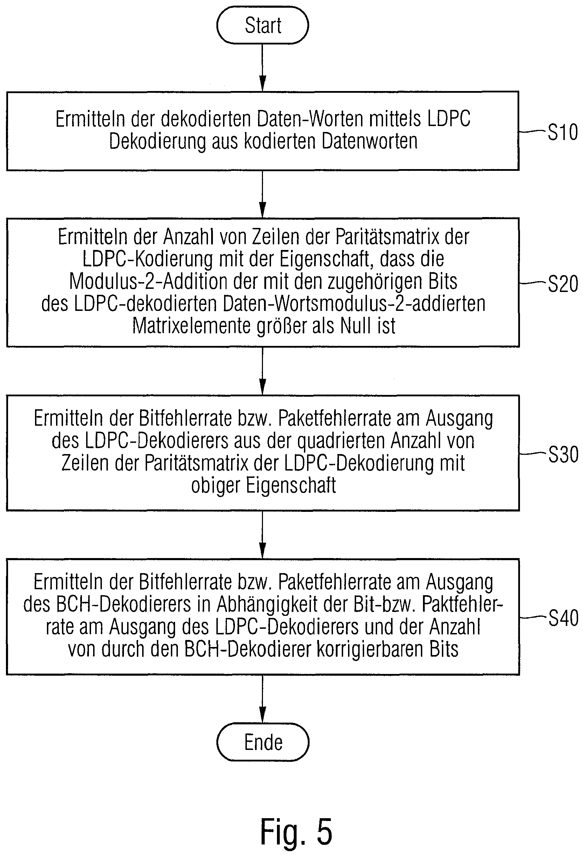

Im Folgenden wird das erfindungsgemäße Verfahren zur Ermittlung einer Bitfehlerrate anhand des Flussdiagrammes in Fig. 5 in Kombination mit der erfindungsgemäßen Vorrichtung zur Ermittlung einer Bitfehlerrate anhand des Blockdiagramms in Fig. 3 im Detail erläutert.

Im ersten Verfahrensschritt S10 des erfindungsgemäßen Verfahrens werden in einem digitalen Fernsehübertragungssystem im Ausführungsbeispiel nach dem DVB-T2-, DVB-S2- oder DVB-C2-Standard verkettet kodierte Daten-Worte, bevorzugt BCH- und LDPC-kodierte Daten-Worte, mittels LDPC-Dekodierung in LDPC-dekodierte Daten-Worte dekodiert.

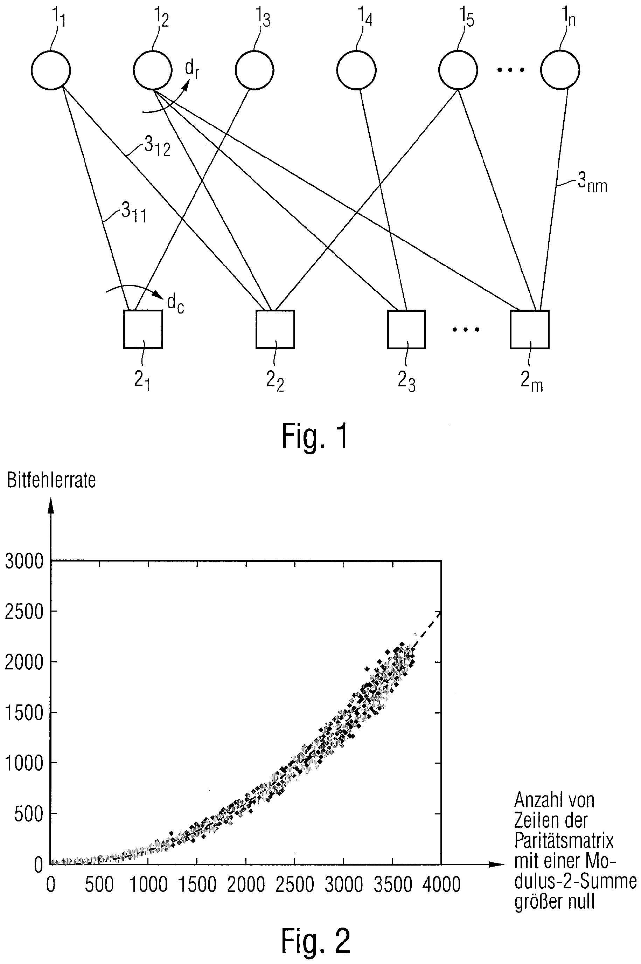

Hierzu wird ein gängiges LDPC-Dekodierungsverfahren verwendet. Hierzu wird beispielsweise der in Fig. 1 dargestellte Tanner-Graph benutzt, bei dem eine Anzahl von variablen Knoten 1₁,1₂,1₃,1₄,1₅,...,1ₙ entsprechend der Anzahl von Bits in einem LDPC-kodierten Daten-Wort einer Anzahl von Check-Knoten 2₁,2₂,2₃,..., 2ₘ gegenübergestellt wird. Jeder einzelne variable Knoten 1₁,1₂,1₃,1₄,1₅,...,1ₙ ist über jeweils eine Kante 3₁₁, 3₁₂,...,3ₙₘ mit einem oder mehreren Check-Knoten 2₁,2₂,2₃,...,2ₘ verbunden, wobei der Kantengrad dᵥ die Anzahl von Check-Knoten 2₁,2₂,2₃,...,2ₘ beinhaltet, mit dem bzw. denen jeweils ein variabler Knoten 1₁,1₂,1₃,1₄,1₅,...,1ₙ verbunden ist, während der Kantengrad d_{c} die Anzahl von variablen Knoten 1₁,1₂,1₃,1₄, 1₅,...,1ₙ darstellt, mit denen bzw. denen jeweils ein Check-Knoten 2₁,2₂,2₃,...,2ₘ verbunden ist. Zwischen welchem variablen Knoten 1₁,1₂,1₃,1₄,1₅,...,1ₙ und welchem Check-Knoten 2₁,2₂,2₃,...,2ₘ jeweils eine Verbindung über eine Kante 3₁₁,3₁₂,...,3ₙₘ besteht, ergibt sich aus den 1-wertigen Matrixelementen der zum jeweiligen LDPC-Kode gehörigen Paritätsmatrix, wobei die Zeilen der Paritätsmatrix den einzelnen Check-Knoten und die Spalten der Paritätsmatrix den einzelnen variablen Knoten des Tanner-Graphs entsprechen.

In einem LDPC-Dekodierer 4, wie er in Fig. 3 dargestellt ist, werden in einem Initialisierungsschritt den einzelnen variablen Knoten jeweils die einzelnen Bits des LDPC-kodierten Daten-Worts d_{LDPCE} zugewiesen, die wiederum das ihnen zugewiesenen Bit über die jeweils vorhandenen Kanten den ihnen zugeordneten einzelnen Check-Knoten zuführen. In den einzelnen Check-Knoten erfolgt, sobald dies im ersten Schätzeschritt überhaupt möglich ist, anhand der zu Null werdenden binären Verknüpfung der mit den Matrixelementen der zum jeweiligen Check-Knoten gehörigen Zeile der Paritätsmatrix eine Verknüpfung mit den einzelnen Bits des LDPC-kodierten Daten-Worts, insbesondere mit den dem jeweiligen Check-Knoten zugewiesenen Bits. Bei der binären Verknüpfung werden zuerst die dem jeweiligen Check-Knoten zugewiesenen Bits jeweils mit dem Bitwert Eins - entsprechend den 1-wertigen Matrixelementen der zum jeweiligen Check-Knoten gehörigen Zeile der Paritätsmatrix - Modulus-2-addiert und anschließend die Ergebnisse der einzelnen Modulus-2-Additionen nochmals Modulus-2-addiert. Je nach Belegung der Matrixelemente der zum jeweiligen Check-Knoten gehörigen Zeile der Paritätsmatrix und der dem jeweiligen Check-Knoten von den einzelnen variablen Knoten im jeweiligen Schritt zugewiesenen Bits weist der Check-Knoten jedem einzelnen variablen Knoten im Rahmen einer harten Entscheidung in Abhängigkeit des von den übrigen variablen Knoten jeweils transferierten Bitwerts einen Bitwert zu. Hierbei kann es dem jeweiligen Check-Knoten möglich sein, für einen variablen Knoten im Rahmen einer harten Entscheidung eine eindeutige Schätzung des Bitwerts durchzuführen.

Die in den einzelnen Check-Knoten für die einzelnen verbundenen variablen Knoten jeweils geschätzten Bit-Werte werden über die jeweiligen Kanten den zugeordneten variablen Knoten wieder zugeführt. Jeder variable Knoten ermittelt anhand des im Initialisierungsschritt zugewiesenen Bitwerts und aller von den einzelnen zugeordneten Check-Knoten jeweils geschätzten Bitwerte beispielsweise anhand einer Mehrheitsentscheidung einen realistischen Bitwert. Für den Fall, dass in jedem einzelnen variablen Knoten keine Mehrheitsentscheidung erforderlich ist, da die dem jeweiligen variablen Knoten jeweils zugewiesenen Werte alle identisch sind, ist die Dekodierung beendet und die in den einzelnen variablen Knoten jeweils enthalten Bitwerte entsprechen den einzelnen Bitwerten des LDPC-dekodierten Daten-Worts.

In allen übrigen Fällen werden die beispielsweise anhand einer Mehrheitsentscheidung in den einzelnen variablen Knoten ermittelten Bitwerte in einem nächsten Iterationsschritt wieder den einzelnen Check-Knoten zugeführt, die wiederum anhand einer harten Entscheidung typischerweise aufgrund einer besseren Entscheidungssituation jeweils einen Bitwert für jeden verbundenen variablen Knoten schätzen. Die Iteration setzt sich solange fort, bis entweder in allen Check-Knoten eine eindeutige Bestimmung des Bit-Wertes von allen mit dem jeweiligen Check-Knoten verbundenen variablen Knoten erzielt ist oder allen variablen Knoten jeweils identische Bitwerte zugewiesen werden und eine Mehrheitsentscheidung nicht mehr erforderlich ist.

Da die auf diese Weise ermittelbaren Bitwerte des LDPC-dekodierten Daten-Wortes beispielsweise aufgrund von zyklischen Abhängigkeiten zwischen einzelnen variablen Knoten und einzelnen Check-Knoten im Tanner-Graph oder aufgrund einer aus Rechenzeitgründen nach einer bestimmten Iterationsanzahl unvollendet abgebrochenen LDPC-Dekodierung nicht korrekt bestimmbar und damit fehlerhaft sind, weisen die einzelnen LDPC-dekodierten Daten-Worte d_{LDPCA} am Ausgang des LDPC-Dekodierers 4 eine von Null verschiedene Bit- oder Paketfehlerrate auf. Somit werden die LDPC-dekodierten Daten-Worte d_{LDPCA} in einem dem LDPC-Dekodierer 4 nachfolgenden BCH-Dekodierer 5, der eine Kode-Rate von fast Eins aufweist, zugeführt, der in der Lage ist, eine bestimmte Anzahl t von fehlerhaften Bits im LDPC-dekodierten Daten-Wort d_{LDPCA} zu korrigieren und ein BCH-dekodiertes Daten-Wort d_{BCH} zu erzeugen, das in vielen Fällen ein gültiges und korrekt dekodiertes Daten-Wort darstellt, aber in einigen Fällen auch ein gültiges und nicht korrekt dekodiertes Daten-Wort generiert. Insbesondere für diesen Fall ist die erfindungsgemäße Ermittlung einer Bitfehlerrate am Ausgang des BCH-Dekodierers 5, die im Folgenden erläutert wird, bestimmt.

Hierzu wird im nächsten Verfahrensschritt S20 in einer Einheit 6 zum Ermitteln der Bit- und/oder Paketfehlerrate am Ausgang des LDPC-Dekodierers die Anzahl von Zeilen in einer zur verwendeten LDPC-Dekodierung gehörigen Paritätsmatrix ermittelt, deren Matrixelemente bei einer binären Verknüpfung mit den einzelnen Bitwerten des LPC-dekodierten Daten-Worts einen Wert größer Null ergeben. Bei der binären Verknüpfung werden zuerst die einzelnen Bits des LDPC-dekodierten Daten-Worts mit den zugehörigen Matrixelementen der jeweilige Zeile der Paritätsmatrix Modulus-2-addiert und anschließend die Ergebnisse der einzelnen Modulus-2-Additionen nochmals Modulus-2-addiert.

Im nächsten Verfahrensschritt S30 wird anhand einer vorab bestimmten quadratischen Kennlinie gemäß Fig. 2 die Bit-Fehlerrate BER_{LDPC} am Ausgang des LDPC-Dekodierers 4 in Abhängigkeit der im vorherigen Verfahrensschritt S20 ermittelten Anzahl von Zeilen der Paritätsmatrix, deren Matrixelemente bei der obig erwähnten binären Verknüpfung mit den einzelnen Bitwerten des LPC-dekodierten Daten-Worts einen Wert größer Null ergeben, bestimmt.

Da die Bit-Fehlerrate bei einer Betrachtung über mehrere LDPC-dekodierte Daten-Worte um einen Mittelwert streuen kann, wird zur Bestimmung einer Bit-Fehlerrate BER_{LDPC} mit einer hohen Signifikanz eine Mittelung über mehrere Bit-Fehlerraten durchgeführt, die jeweils für ein LDPC-dekodiertes Daten-Wort aus einer Sequenz von mehreren aufeinander folgenden LDPC-dekodierte Daten-Worte jeweils ermittelt werden. Zur Ermittlung einer Paket-Fehlerrate PER_{LDPC} wird das Verhältnis der Anzahl der von Null verschiedenen Bit-Fehlerraten BER_{LDPC}, die für jeweils ein LDPC-dekodiertes Daten-Wort ermittelten werden, zur Anzahl der zu Null identischen Bit-Fehlerraten BER_{LDPC}, die für jeweils ein LDPC-dekodiertes Daten-Wort ermittelt werden, bestimmt.

Zur Vorabbestimmung der quadratischen Kennlinie gemäß Fig. 2 wird nach Beendigung einer LDPC-Dekodierung eines LDPC-dekodierten Daten-Wortes die Anzahl der Check-Knoten im Tanner-Graph ermittelt, für die eine Modulus-2-Summe aus den Modulation-2-Summen jedes Bits des LDPC-dekodierten Daten-Wortes mit dem Bitwert Eins einen Wert größer null ergibt. Die Anzahl der Check-Knoten, die nach der LDPC-Dekodierung eines LDPC-kodierten Daten-Worts diese Eigenschaft aufweisen, wird quadriert. Die quadrierte Anzahl von Check-Knoten mit dieser Eigenschaft stellt ein Maß für die Anzahl von fehlerhaften Bits im LDPC-dekodierten Daten-Wort dar. Werden für mehrere aufeinander folgende LDPC-dekodierte Daten-Worte die jeweils quadrierte Anzahl von Check-Knoten mit dieser Eigenschaft ermittelt, so gibt sich die Fig. 2 dargestellte Wertepaaren-Verteilung.

Die gestrichelt in Fig. 2 dargestellte quadratische Kennlinie, die eine quadratische Kennlinie mit hoher Signifikanz darstellt und den Zusammenhang zwischen der Anzahl von Check-Knoten mit der obig genannten Eigenschaft und der mittleren Bit-Fehlerrate bestimmt, wird in einer ersten Untervariante der Erfindung durch Mittelung über alle Wertepaare und in einer zweiten Untervariante der Erfindung durch Minimierung der mittleren Fehlerquadrate über alle Wertepaare bestimmt.

Im darauf folgenden Verfahrenschritt S40 wird in einer Einheit 6 zum Ermitteln der Bit- oder Paketfehlerrate am Ausgang des Block-Dekodierers in Abhängigkeit des im letzten Verfahrenschritt S30 ermittelten Bit- und/oder Paketfehlerrate am Ausgang des LDPC-Dekodierers 4 und der vom BCH-Dekodierer 5 korrigierbaren Anzahl t von Bits in einem LDPC-dekodierten Daten-Wort die Bit-Fehlerrate BER_{BCH} und/oder die Paketfehlerrate PER_{BCH} am Ausgang des BCH-Dekodierers 5 bestimmt.

In einer ersten Variante der Erfindung ergibt sich eine Bit-Fehlerrate BER_{BCH} bzw. eine Paket-Fehlerrate PER_{BCH} am Ausgang des BCH-Dekodierers 5 von Null, falls die Anzahl von fehlerhaften Bits in einem LDPC-dekodierten Daten-Wort, die sich aus der Multiplikation der Bitanzahl eines LDPC-dekodierten Datenwortes und der im vorherigen Verfahrensschritt S30 ermittelten Bit-Fehlerrate BER_{LDPC} bzw. Paketfehlerrate PER_{LDCP} am Ausgang der LDPC-Dekodierung bestimmen lässt, kleiner oder gleich der Anzahl t vom durch den BCH-Dekodierer 5 korrigierbaren Anzahl von Bits in einem LDPC-dekodierten Daten-Wort ist.

Die Bit-Fehlerrate BER_{BCH} bzw. eine Paket-Fehlerrate PER_{BCH} am Ausgang des BCH-Dekodierers 6 ergibt sich aus dem Wert der Bit-Fehlerrate BER_{LDPC} bzw. Paketfehlerrate PER_{LDCP} am Ausgang der LDPC-Dekodierung, falls die Anzahl von fehlerhaften Bits in einem LDPC-dekodierten Daten-Wort größer als die Anzahl t von durch den BCH-Dekodierer 5 korrigierbaren Anzahl von Bits in einem LDPC-dekodierten Daten-Wort ist.

In diesem Fall erzeugt der BCH-Dekodierer 5 ein gültiges und typischerweise nicht korrektes BCH-dekodiertes Daten-Wort, das vom gültigen und korrekten BCH-dekodierten Daten-Wort um die Anzahl t von durch den BCH-Dekodierer 5 korrigierbaren Bits in einem LDPC-dekodierten Daten-Wort oder um Vielfache davon entfernt ist. Somit wird die Anzahl von fehlerhaften Bits in einem LDPC-dekodierten Daten-Wort, die sich aus der Multiplikation der ermittelten Bit-Fehlerrate BER_{LDPC} am Ausgang der LDPC-Dekodierung und der Anzahl von Bits in einem LDPC-dekodierten Daten-Wort ergibt, auf eine zu einem gültigen und typischerweise nicht korrekten BCH-dekodierten Daten-Wort gehörige Anzahl von fehlerhaften Bits in einem BCH-dekodierten Daten-Wort reduziert. Diese Anzahl von fehlerhaften Bits im BCH-dekodierten Daten-Wort entspricht gemäß der Eigenschaft eines BCH-Dekodierers entweder der Anzahl t von durch den BCH-Dekodierer 5 korrigierbaren Bits in einem BCH-dekodierten Daten-Wort oder Vielfachen der Anzahl t von durch den BCH-Dekodierer 5 korrigierbaren Bits in einem BCH-dekodierten Daten-Wort.

Die Bit-Fehlerrate BER_{BCH} am Ausgang des BCH-Dekodierers 6 ergibt sich folglich in diesem Fall aus der Mittelung von zu mehreren BCH-dekodierten Daten-Worten jeweils ermittelten Bit-Fehlerraten BER_{BCH}, wobei sich eine zu einem BCH-dekodierten Daten-Wort jeweils gehörige Bit-Fehlerrate BER_{BCH} aus dem Verhältnis der Anzahl von fehlerhaften Bits zur Anzahl von korrekten Bits in einem BCH-dekodierten Daten-Wort ermitteln lässt.

Die Paket-Fehlerrate PER_{BCH} am Ausgang des BCH-Dekodierers 6 wiederum lässt sich aus dem Verhältnis der Anzahl von fehlerfrei BCH-dekodierten Daten-Worten zur Anzahl von fehlerhaft BCH-dekodierten Daten-Worten ermitteln.

In einer zweiten Variante der Erfindung wird die Tatsache gemäß Fig. 4 ausgenutzt, dass 98,83% aller variablen Knoten in einem Tanner-Graph jeweils mit einem, mit zwei oder mit drei Check-Knoten verbunden sind, während ein nur sehr kleiner und damit vernachlässigbarer Anteil von 1,17% aller variablen Knoten mit m Check-Knoten verbunden ist. Der Wert m ist dabei von der Kode-Rate des verwendeten LDPC-Kodierungsverfahrens abhängig und beträgt beispielsweise für eine Kode-Rate von 2/3 13. Da die Anzahl von durch den BCH-Dekodierer 5 korrigierbaren und zu jeweils einem variablen Konten gehörigen Bitwerten im zweistelligen Bereich liegt und damit zur fünfstelligen Gesamtanzahl von variablen Knoten vergleichsweise klein ist, sind die mit jedem korrigierbaren variablen Knoten jeweils verbundenen Check-Knoten aufgrund der ebenfalls hohen Anzahl von Check-Knoten typischerweise jeweils unterschiedlich zueinander. Somit ergibt sich eine Bit-Fehlerrate BER_{BCH} bzw. eine Paket-Fehlerrate PER_{BCH} am Ausgang des BCH-Dekodierers 5 von Null, wenn die Anzahl von Check-Knoten mit der Eigenschaft, dass die Modulo-2-addierten Bitwerte von mit dem jeweiligen Check-Knoten über Kanten jeweils verbundenen variablen Knoten einen Wert größer als Null aufweisen, kleiner oder gleich der dreifachen Anzahl t von durch den BCH-Dekodierer 5 im LDPC-dekodierten Daten-Wort korrigierbaren Bits ist.

Äquivalent ergibt sich in der zweiten Variante der Erfindung eine Bit-Fehlerrate BER_{BCH} bzw. eine Paket-Fehlerrate PER_{BCH} am Ausgang des BCH-Dekodierers 5 von Null, falls die Anzahl von Zeilen der in der LDPC-Dekodierung verwendeten Paritätsmatrix, deren Matrixelemente bei einer binären Verknüpfung mit den einzelnen Bitwerten des LPC-dekodierten Daten-Worts einen Wert größer Null ergeben, kleiner oder gleich der dreifachen Anzahl t von durch den BCH-Dekodierer 5 im LDPC-dekodierten Daten-Wort korrigierbaren Bits ist. Bei der binären Verknüpfung handelt es sich wieder um die Modulus-2-Addition der Bits des LDPC-dekodierten Daten-Worts mit den zugehörigen Matrixelementen der jeweiligen Zeile der Paritätsmatrix und um die zusätzliche Modulus-2-Addition der einzelnen Modulus-2-Additionen-Ergebnisse.

Die Bit-Fehlerrate BER_{BCH} am Ausgang des BCH-Dekodierer 5 ergibt sich in der zweiten Variante der Erfindung aus dem Wert der Bit-Fehlerrate BER_{LDPC} bzw. Paketfehlerrate PER_{LDCP} am Ausgang der LDPC-Dekodierung, falls die Anzahl von fehlerhaften Bits in einem LDPC-dekodierten Daten-Wort größer der dreifachen Anzahl t vom durch den BCH-Dekodierer 5 korrigierbaren Anzahl von Bits in einem LDPC-dekodierten Daten-Wort ist. In diesem Fall erzeugt der BCH-Dekodierer 5 ein gültiges und typischerweise nicht korrektes BCH-dekodiertes Daten-Wort, das vom gültigen und korrekten BCH-dekodierten Daten-Wort um die dreifache Anzahl t von durch den BCH-Dekodierer 5 korrigierbaren Bits in einem LDPC-dekodierten Daten-Wort oder um Vielfache davon entfernt ist. Somit wird die Anzahl von fehlerhaften Bits in einem LDPC-dekodierten Daten-Wort, die sich aus der Multiplikation der ermittelten Bit-Fehlerrate BER_{LDPC} am Ausgang der LDPC-Dekodierung und der Anzahl von Bits in einem LDPC-dekodierten Daten-Wort ergibt, auf eine zu einem gültigen und typischerweise nicht korrekten BCH-dekodierten Daten-Wort gehörige Anzahl von fehlerhaften Bits reduziert. Diese Anzahl von fehlerhaften Bits im BCH-dekodierten Daten-Wort entspricht gemäß der Eigenschaft eines BCH-Dekodierers 5 entweder der dreifachen Anzahl t von durch den BCH-Dekodierer 5 korrigierbaren Bits in einem BCH-dekodierten Daten-Wort oder Vielfachen der dreifachen Anzahl t von durch den BCH-Dekodierer 5 korrigierbaren Bits in einem BCH-dekodierten Daten-Wort. Die Bit-Fehlerrate BER_{BCH} am Ausgang des BCH-Dekodierers 5 ergibt sich folglich in diesem Fall aus dem Verhältnis zwischen der Anzahl von fehlerhaften Bits im BCH-dekodierten Daten-Wort und der Anzahl von Bits im BCH-dekodierten Daten-Wort.

Die Paket-Fehlerrate PER_{BCH} am Ausgang des BCH-Dekodierers 5 wiederum lässt sich auch in einer zweiten Variante der Erfindung aus dem Verhältnis der Anzahl von fehlerfrei BCH-dekodierten Daten-Worten zur Anzahl von fehlerhaft BCH-dekodierten Daten-Worten ermitteln.

Die Erfindung ist nicht auf die dargestellten Varianten beschränkt. Von der Erfindung sind insbesondere alle Kombinationen aller in den Patentansprüchen beanspruchten Merkmale, aller in der Beschreibung offenbarten Merkmale und aller in den Figuren der Zeichnung dargestellten Merkmale mit abgedeckt. Statt einer BCH-Dekodierung kann auch eine andere Block-Dekodierung zum Einsatz kommen.

## Patentansprüche

1. Verfahren zur automatischen Ermittlung einer zweiten Bitfehlerrate eines dekodierten Bitstroms eines Nachrichtensignals nach einer Block-Dekodierung mittels eines Block-Dekodierers (5), der einem LDPC-Dekodierer (4) zur LDPC-Dekodierung (S10) nachgeschaltet ist,
wobei eine Ermittlungseinheit (6) eine erste Bitfehlerrate (S30) nach der LDPC-Dekodierung ermittelt und eine nachgeschaltete Ermittlungseinheit (7) die zweite Bitfehlerrate aus der ermittelten ersten Bitfehlerrate und einer ersten Anzahl von durch die Block-Dekodierung korrigierbaren Bits in einem am Eingang der Block-Dekodierung anliegenden kodierten Daten-Wort ermittelt,
**dadurch gekennzeichnet,**
**dass** die Ermittlungseinheit (6) die erste Bitfehlerrate in Abhängigkeit einer zweiten Anzahl von zu einer Paritätsmatrix der LDPC-Dekodierung gehörigen Zeilen ermittelt (S20), für die die Modulus-2-Summe aller mit den Matrix-Elementen der jeweiligen Zeile Modulus-2-addierten Bits des LDPC-dekodierten Daten-Worts einen von Null verschiedenen Wert ergibt, und
**dass** die nachgeschaltete Ermittlungseinheit (7) die zweite Bitfehlerrate als Null ermittelt, falls die zweite Anzahl kleiner oder gleich der dreifachen ersten Anzahl ist.

2. Verfahren nach Anspruch 1,
**dadurch gekennzeichnet,**
**dass** die Block-Dekodierung eine Kode-Rate aufweist, die fast Eins ist, insbesondere die größer 0,98 und kleiner 1 ist.

3. Verfahren nach Anspruch 1 oder 2,
**dadurch gekennzeichnet,**
**dass** die Block-Dekodierung eine BCH-Dekodierung ist.

4. Verfahren nach einem der Ansprüche 1 bis 3,
**dadurch gekennzeichnet,**
**dass** die Abhängigkeit eine quadratische Abhängigkeit ist.

5. Verfahren nach Anspruch 4,
**dadurch gekennzeichnet,**
**dass** die quadratische Abhängigkeit mittels Mittelung von mehreren Werte-Paaren ermittelt wird.

6. Verfahren nach Anspruch 4,
**dadurch gekennzeichnet,**
**dass** die quadratische Abhängigkeit mittels Minimierung von quadratischen Fehlerquadraten ermittelt wird.

7. Verfahren nach einem der Ansprüche 1 bis 6,
**dadurch gekennzeichnet,**
**dass** für die Ermittlung der ersten Bitfehlerrate nach der LDPC-Dekodierung jeweils die Bits von mehreren aufeinander folgenden kodierten Daten-Worten berücksichtigt werden.

8. Vorrichtung zur automatischen Ermittlung einer zweiten Bitfehlerrate eines dekodierten Bitstroms am Ausgang eines Block-Dekodierers (5), der einem LDPC-Dekodierer (4) nachgeschaltet ist, mit einer Einheit (6) zum Ermitteln einer ersten Bitfehlerrate am Ausgang des LDPC-Dekodierers und einer nachgeschalteten Einheit (7) zum Ermitteln der zweiten Bitfehlerrate am Ausgang des Block-Dekodierers (5),
wobei die nachgeschaltete Einheit (7) dazu ausgelegt ist, die zweite Bitfehlerrate aus der ersten Bitfehlerrate und einer ersten Anzahl von durch die Block-Dekodierung mittels des Block-Dekodierers (5) korrigierbaren Bits in einem am Eingang des Block-Dekodierers (5) anliegenden kodierten Daten-Wort zu ermitteln,
**dadurch gekennzeichnet,**
**dass** die Einheit (6) dazu ausgelegt ist, die erste Bitfehlerrate in Abhängigkeit einer zweiten Anzahl von zu einer Paritätsmatrix der LDPC-Dekodierung gehörigen Zeilen zu ermitteln, für die die Modulus-2-Summe aller mit den Matrix-Elementen der jeweiligen Zeile Modulus-2-addierten Bits des LDPC-dekodierten Daten-Worts einen von Null verschiedenen Wert ergibt, und
**dass** die nachgeschaltete Einheit (7) dazu ausgelegt ist, die zweite Bitfehlerrate als Null zu ermitteln, falls die zweite Anzahl kleiner oder gleich der dreifachen ersten Anzahl ist.

9. Vorrichtung nach Anspruch 8,
**dadurch gekennzeichnet,**
**dass** der Block-Dekodierer (5) ein BCH-Dekodierer ist, dessen Kode-Rate fast Eins ist, insbesondere größer 0,98 und kleiner 1 ist.

10. Computerprogramm mit Programmcode-Mitteln, das alle Verfahrensschritte der Ansprüche 1 bis 7 ausführt, wenn das Programm auf einem programmierbaren Computer und/oder einem digitalen Signalprozessor ausgeführt wird.

11. Computer-lesbares Speichermedium mit darauf gespeicherten Programmcode-Mitteln, das alle Verfahrensschritte der Ansprüche 1 bis 7 ausführt, wenn das Programm auf einem programmierbaren Computer und/oder einem digitalen Signalprozessor ausgeführt wird.

## Claims

1. A method for automatically determining a second bit error rate of a decoded bit stream of a message signal after a block decoding by means of a block decoder (5), which is arranged downstream of an LDPC decoder (4) for LDPC decoding (S10),
wherein a determining unit (6) determines a first bit error rate (S30) after the LDPC decoding and a determining unit (7) arranged downstream determines the second bit error rate from the determined first bit error rate and a first number of bits correctable by the block decoding in a data word lying at the input of the block decoding,
**characterized in that**
the determining unit (6) determines the first bit error rate in dependence on a second number of rows belonging to a parity matrix of the LDPC decoding (S20), for which the modulo 2 sum of all modulo 2 added bits of the LDPC decoded data word with the matrix elements of the respective row yields a value different from zero, and
that the determining unit (7) arranged downstream determines the second bit error rate as zero, if the second number is less than or equal to three times the first number.

2. The method according to claim 1,
**characterized in that**
the block decoding has a code rate which is almost one, in particular is greater than 0.98 and less than 1.

3. The method according to claim 1 or 2,
**characterized in that**
the block decoding is a BCH decoding.

4. The method according to any of claims 1 to 3,
**characterized in that**
the dependence is a quadratic dependence.

5. The method according to claim 4,
**characterized in that**
the quadratic dependence is determined by means of averaging a plurality of pairs of values.

6. The method according to claim 4,
**characterized in that**
the quadratic dependence is determined by means of minimizing quadratic squared errors.

7. The method according to any of claims 1 to 6,
**characterized in that**
in each case the bits of a plurality of consecutive coded data words are considered in the determination of the first bit error rate after the LDPC decoding.

8. A device for the automatic determination of a second bit error rate of a decoded bitstream at the output of a block decoder (5), which is arranged downstream of an LDPC decoder (4), having a unit (6) for determining a first bit error rate at the output of the LDPC decoder and a unit (7) arranged downstream for determining the second bit error rate at the output of the block decoder (5),
wherein the unit (7) arranged downstream is designed to determine the second bit error rate from the first bit error rate and a first number of bits correctable by the block decoding by means of the block decoder (5) in a coded data word lying at the input of the block decoder (5),
**characterized in that**
the unit (6) is designed to determine the first bit error rate depending on a second number of rows belonging to a parity matrix of the LDPC decoding, for which the modulo 2 sum of all modulo 2 added bits of the LDPC decoded data word with the matrix elements of the respective row yields a value different from zero, and
**in that** the unit (7) arranged downstream is designed to determine the second bit error rate as zero, if the second number is less than or equal to three times the first number.

9. The device according to claim 8,
**characterized in that**
the block decoder (5) is a BCH decoder whose code rate is almost one, in particular greater than 0.98 and less than 1.

10. A computer program with program code means that executes all the method steps of claims 1 to 7 when the program is executed on a programmable computer and/or a digital signal processor.

11. A computer-readable storage medium with program code means that executes all the method steps of claims 1 to 7 when the program is executed on a programmable computer and/or a digital signal processor.

## Revendications

1. Procédé destiné à déterminer automatiquement un second taux d'erreur sur les bits d'un train de bits décodé d'un signal de communication après un décodage de bloc au moyen d'un décodeur de bloc (5) qui est monté en aval d'un décodeur LDPC (4) pour un décodage LDPC (S10),
dans lequel une unité de détermination (6) détermine un premier taux d'erreur sur les bits (S30) après le décodage LDPC, et une unité de détermination (7) montée en aval détermine, dans un mot de donnée codé qui se trouve à l'entrée du décodage de bloc, le second taux d'erreur sur les bits à partir du premier taux d'erreur sur les bits déterminé et d'un premier nombre de bits corrigibles par le décodage de bloc,
**caractérisé en ce que**
l'unité de détermination (6) détermine le premier taux d'erreur sur les bits sous la dépendance d'un second nombre de lignes qui appartient à une matrice de parité du décodage de bloc (S20), pour lesquelles la somme module 2 de tous les bits du mot de donnée issu du décodage LDPC additionnés par module 2 avec les éléments de matrice de la ligne respective donne une valeur différente de zéro, et
**en ce que** l'unité de détermination (7) montée en aval détermine le second taux d'erreur sur les bits comme étant zéro dans le cas où le second nombre est inférieur ou égal au triple du premier nombre.

2. Procédé selon la revendication 1,
**caractérisé en ce que**
le décodage de bloc présente un taux de codage qui est presque de un, en particulier qui est supérieur à 0,98 et inférieur à 1.

3. Procédé selon la revendication 1 ou 2,
**caractérisé en ce que**
le décodage de bloc est un décodage BCH.

4. Procédé selon l'une des revendications 1 à 3,
**caractérisé en ce que**
la dépendance est une dépendance quadratique.

5. Procédé selon la revendication 4,
**caractérisé en ce que**
la dépendance quadratique est déterminée en moyennant plusieurs paires de valeurs.

6. Procédé selon la revendication 4,
**caractérisé en ce que**
la dépendance quadratique est déterminée en minimisant des carrés d'erreur quadratiques.

7. Procédé selon l'une des revendications 1 à 6,
**caractérisé en ce que**
pour la détermination du premier taux d'erreur sur les bits après le décodage LDPC sont respectivement pris en compte les bits de plusieurs mots de donnée codés qui se succèdent.

8. Dispositif destiné à déterminer automatiquement un second taux d'erreur sur les bits d'un train de bits décodé à une sortie d'un décodeur de bloc (5) qui est monté en aval d'un décodeur LDPC (4), avec une unité (6) pour déterminer un premier taux d'erreur sur les bits à la sortie du décodeur LDPC et une unité (7) montée en aval pour déterminer le second taux d'erreur sur les bits à la sortie du décodeur de bloc (5),
dans lequel l'unité (7) montée en aval est configurée pour déterminer le second taux d'erreur sur les bits à partir du premier taux d'erreur sur les bits et d'un premier nombre de bits corrigibles par le décodage de bloc au moyen du décodeur de bloc (5) dans un mot de donnée codé qui se trouve à l'entrée du décodeur de bloc (5),
**caractérisé en ce que**
l'unité (6) est configurée pour déterminer le premier taux d'erreur sur les bits sous la dépendance d'un second nombre de lignes qui appartient à une matrice de parité du décodage de bloc, pour lesquelles la somme module 2 de tous les bits du mot de donnée issu du décodage LDPC additionnés par module 2 avec les éléments de matrice de la ligne respective donne une valeur différente de zéro, et
**en ce que** l'unité (7) montée en aval est configurée pour déterminer le second taux d'erreur sur les bits comme étant zéro dans le cas où le second nombre est inférieur ou égal au triple du premier nombre.

9. Dispositif selon la revendication 8,
**caractérisé en ce que**
le décodeur de bloc (5) est un décodeur BCH, dont le taux de codage est presque de un, en particulier supérieur à 0,98 et inférieur à 1.

10. Programme informatique avec des moyens de code de programme, qui exécute toutes les étapes de procédé des revendications 1 à 7 lorsque le programme est exécuté sur un ordinateur programmable et/ou un processeur de signalisation numérique.

11. Support de stockage lisible par ordinateur avec des moyens de code de programme stockés sur celui-ci, qui exécute toutes les étapes de procédé des revendications 1 à 7 lorsque le programme est exécuté sur un ordinateur programmable et/ou un processeur de signalisation numérique.
